(19) Europäisches Patentamt / European Patent Office / Office européen des brevets

(11) **EP 2 573 820 A2**

(12) **EUROPEAN PATENT APPLICATION**

(43) Date of publication:
**27.03.2013 Bulletin 2013/13**

(51) Int Cl.:
***H01L 31/032*** *(2006.01)*

(21) Application number: **12162027.2**

(22) Date of filing: **29.03.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (72) Inventors:<br>• **Liao, Yueh-Chun**<br>  **35053 Miaoli County (TW)**<br>• **Yang, Feng-Yu**<br>  **35053 Miaoli County (TW)**<br>• **Ting, Ching**<br>  **35053 Miaoli County (TW)** |
| (30) Priority: **23.09.2011  US 201113241248** | (74) Representative: **Becker Kurig Straus**<br>**Bavariastrasse 7**<br>**80336 München (DE)** |
| (71) Applicant: **DelSolar Co., Ltd.**<br>  **Miaoli County 35053 (TW)** | |

(54) **Photovoltaic device including a CZTS absorber layer and method of manufacturing the same**

(57)     A photovoltaic device (100, 200, 400) including a CZTS absorber layer (130, 230, 430) and method for manufacturing the same are disclosed. The photovoltaic device (100, 200, 400) includes a substrate (110, 210, 410), a bottom electrode layer (120, 220, 420), an absorber layer (130, 230, 430) formed on the bottom electrode layer (120, 220, 420), a buffer layer (140, 240, 440) formed on the absorber layer (130, 230, 430) and a top electrode layer (150, 250, 450) formed on the buffer layer (140, 240, 440). The absorber layer (130, 230, 430) includes a first region (231) adjacent to the bottom electrode layer (120, 220, 420) and a second region (232) adjacent to the first region (231). Both of the first region (231) and the second region (232) include a formula of $Cu_a(Zn_{1-b}Sn_b)(Se_{1-c}S_c)_2$, wherein $0<a<1$, $0<b<1$, $0 \leq c \leq 1$ and a Zn/Sn ratio of the first region (231) is higher than that of the second region (232).

FIG.2

**Description**

Field of the Invention

The present invention relates to a photovoltaic device including a czts absorber layer and a method of manufacturing the same according to the pre-characterizing clause of claims 1, 10 and 19.

Background of the Invention

Photovoltaic devices have recently attracted attention due to energy shortages on Earth. The photovoltaic devices can be boldly classified into crystalline silicon solar cells and thin film solar cells. Crystalline silicon solar cells are the main stream photovoltaic device owing to its mature manufacturing technology and high efficiency. However, crystalline silicon solar cells are still far from common practice because of their high material and manufacturing cost. Thin film solar cells are made by forming a light absorbing layer on a non-silicon substrate, such as glass substrate. Glass substrate has no shortage concern and the price thereof is cheaper than silicon wafers used in crystalline silicon solar cells. Therefore, thin film solar cells are considered as an alternative to crystalline silicon solar cells.

Thin film solar cells can be further classified by the material of the light absorbing layers, such as amorphous silicon, multi-crystalline silicon, Cadmium Telluride (CdTe), Copper indium gallium selenide (CIS or CIGS), Dye-sensitized film (DSC) and other organic films. Among these thin film solar cells, a CIGS solar cell has reached cell efficiency of 20%, which is comparable with crystalline silicon solar cells. However, CIGS solar cells include rare and expensive elements, i.e., indium and gallium such that they are not well spread in commercial use.

The quaternary chalcogenide semiconductor $Cu_2ZnSn(S,Se)_4$ (CZTS) is a new photovoltaic material which has attracted interests recently due to its low cost, naturally abundant and non-toxic elements. CZTS is a direct band gap material and includes band gap energy of about 1.5 eV and absorption coefficient greater than 104 cm-1. The methods of synthesising CZTS absorber film can be classified into vacuum and non-vacuum based methods. The vacuum based methods include deposition of the constitute elements by sputtering or evaporation. The non-vacuum based methods include preparing the CZTS absorber film by spray pyrolysis, electrochemical deposition, or spin coating of precursor solutions. All the methods mentioned above have been utilized in many approaches to improve conversion efficiency of CZTS-based solar cells.

Summary of the Invention

This in mind, the present invention aims at providing a photovoltaic device including a CZTS absorber layer and a method of manufacturing the same to improve conversion efficiency.

This is achieved by a photovoltaic device including a CZTS absorber layer and a method of manufacturing the same according to claims 1, 10 and 19. The dependent claims pertain to corresponding further developments and improvements.

As will be seen more clearly from the detailed description following below, the claimed photovoltaic device includes a substrate, a bottom electrode, an absorber layer formed on the bottom electrode, a buffer layer formed on the absorber layer and a top electrode layer formed on the buffer layer. The absorber layer includes a first region adjacent to the bottom electrode and a second region adjacent to the first region. Both of the first region and the second region include a formula of $Cu_a(Zn_{1-b}Sn_b)(Se_{1-c}S_c)_2$, wherein 0<a<1, 0<b<1, 0≦c≦1 and a Zn/Sn ratio of the first region is higher than that of the second region.

A method for manufacturing a photovoltaic device having a CZTS absorber layer includes steps of: forming a bottom electrode on a substrate, forming an absorber layer including a gradient composition region on the bottom electrode layer, forming a semiconductor layer on the absorber layer and forming a top electrode layer on the semiconductor layer. The absorber layer includes a formula of $Cu_a(Zn_{1-b}Sn_b)(Se_{1-c}S_c)_2$, wherein 0<a<1, 0<b<1, 0≦c≦1, and the gradient composition region includes gradient Zn/Sn ratio and a higher Zn/Sn ratio at a side adjacent to the bottom electrode layer.

Brief Description of the Drawings

The above and other objects, features and other advantages of the present application will be more clearly understood from the following detailed description taken in conjunction with the accompanying drawings, in which:

FIG.1 is a schematic view of an ordinary CZTS-based photovoltaic device,
FIG.2 is a schematic view of a CZTS-based photovoltaic device according to an embodiment of the present application,

FIG.3 is a flow chart of a fabrication method of a CZTS-based photovoltaic device as shown in FIG.2, and FIG.4 is a schematic view of a CZTS-based photovoltaic device according to another embodiment of the present application.

Detailed Description

Hereinafter, "CZTS" refers to a chalcogenide semiconductor material having a formula of $Cu_a(Zn_{1-b}Sn_b)$ $(Se_{1-c}S_c)_2$, wherein 0<a<1, 0<b<1, 0≦c≦1. "CZTS absorber layer" refers absorber layers which include a CZTS material. "CZTS-based photovoltaic device" refers to photovoltaic devices which include a CZTS absorber layer. "CZTS precursor solution" refers to precursor solutions which can be used to form a CZTS absorber layer.

Reference throughout this specification to "one embodiment," "an embodiment," or similar language means that a particular feature, structure, or characteristic described in connection with the embodiment is included in at least one embodiment of the present application. Thus, appearances of the phrases "in one embodiment," "in an embodiment," and similar language throughout this specification may, but do not necessarily, all refer to the same embodiment.

Reference will now be made in detail to the embodiments of the present application, examples of which are illustrated in the accompanying drawings, wherein like reference numerals refer to the like elements throughout. The embodiments are described below in order to explain the present application by referring to the figures.

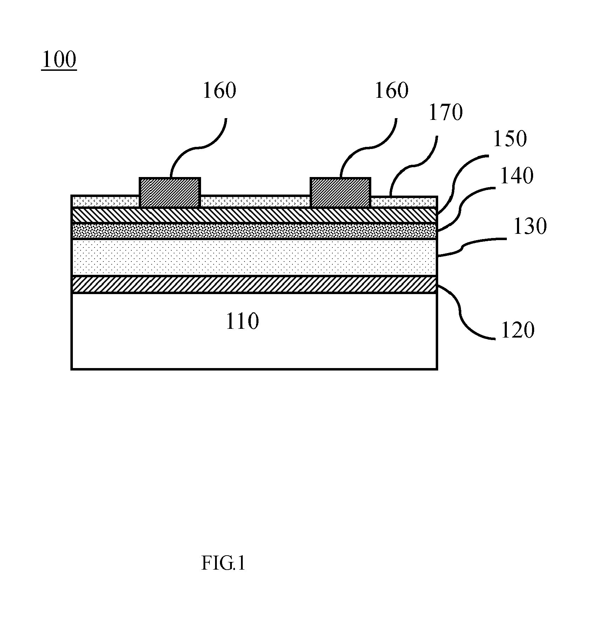

Referring to FIG.1, it is a schematic view of an ordinary CZTS-based photovoltaic device. As shown in FIG.1, the photovoltaic device 100 includes a substrate 110, a bottom electrode layer 120, an absorber layer 130, a buffer layer140, a top electrode layer 150, metal contacts 160 and an anti-reflective layer 170. The bottom electrode layer 120 is formed on the substrate 110. The absorber layer 130 is formed on the bottom electrode layer 120. The buffer layer140 is formed on the absorber layer 130. The top electrode layer 150 is formed on the buffer layer 140. The metal contacts 160 are formed on the top electrode layer 150. The anti-reflective layer 170 is also formed on the surface of the top electrode layer 150.

The substrate 110 includes a material selected from a group consisting of glass, metal foil and plastic. For example, the substrate 110 can be a soda-lime glass substrate.

The bottom electrode layer 120 includes a material selected from a group consisting of molybdenum (Mo), tungsten (W), aluminum (Al), and Indium Tin Oxide (ITO). Typically, the bottom electrode layer is an Mo layer.

The absorber layer 130 includes a formula of $Cu_a(Zn_{1-b}Sn_b)(Se_{1-c}S_c)_2$, wherein 0<a<1, 0<b<1, 0≦c≦1. The absorber layer 130 can be formed on the bottom electrode layer 120 by coating, electron-beam evaporation, vapor deposition, sputtering, electro-plating, sol-gel method, spray pyrolysis, spray deposition, radiofrequency magnetron sputtering, or electrochemical deposition. The buffer layer 140 includes a semiconductor layer, such as an n-type semiconductor layer or a p-type semiconductor layer. When the absorber layer 130 is p-type, the buffer layer 140 is formed of n-type semiconductor material. The buffer layer includes a material selected from a group consisting of cadmium sulfide (CdS), Zn(O,OH,S), indium selenide ($In_2Se_3$) zinc sulfide (ZnS), and zinc magnesium oxide ($Zn_xMg_{1-x}O$). Typically, the buffer layer 140 is formed of CdS by chemical bath deposition.

The top electrode layer 150 includes a transparent conductive layer. For example, the top electrode layer 1240 includes a material selected from a group consisting of zinc oxide (ZnO), indium tin oxide (ITO), boron-doped zinc oxide (B-ZnO), aluminum-doped zinc oxide (Al-ZnO), gallium-doped zinc oxide (Ga-ZnO), and antimony tin oxide (ATO). In this example, a zinc oxide (ZnO) film and an indium tin oxide film (ITO) are formed as the top electrode layer 150 on the buffer layer 140.

The metal contacts 160 can be, for example, nickel (Ni)/ aluminum (Al) layers.

The anti-reflective layer 170 includes a material selected from a group consisting of magnesium fluoride ($MgF_2$), silicon oxide ($SiO_2$), silicon nitride ($Si_3N_4$) and Niobium oxide ($NbO_x$).

As mentioned above, the absorber layer 130 of the photovoltaic device 100 includes a formula of $Cu_a(Zn_{1-b}Sn_b)$ $(Se_{1-c}S_c)_2$, wherein 0<a<1, 0<b<1, 0≦c≦1. In more detail, the absorber layer 130 has a chemical composition with specific molar ratios between copper, zinc and tin. For example, the absorber layer has a chemical composition of Cu/(Zn+Sn)=0.87, Zn/Sn=1.15. The molar ratios between these elements may have an influence on characteristics of the photovoltaic device.

It has been found that an efficiency of the photovoltaic device 100 is partially limited by its low open circuit voltage Voc. The relation between open circuit voltage Voc and conversion efficiency η of a photovoltaic device can be expressed by the following equation (A):

$$\eta = V_{oc} \cdot J_{sc} \cdot F.F./P_{in} \times 100 \qquad (A)$$

wherein $J_{sc}$ refers to short circuit current, F.F. refers to fill factor and $P_{in}$ refers to incident power density. From the equation (A), it can be understood that the conversion efficiency $\eta$ can be improved by increasing any of the open circuit voltage $V_{oc}$, the short circuit current $J_{sc}$ and the fill factor F.F.. The present application implements several embodiments which are verified to have an improvement in controlling the open circuit voltage of CZTS-based photovoltaic device.

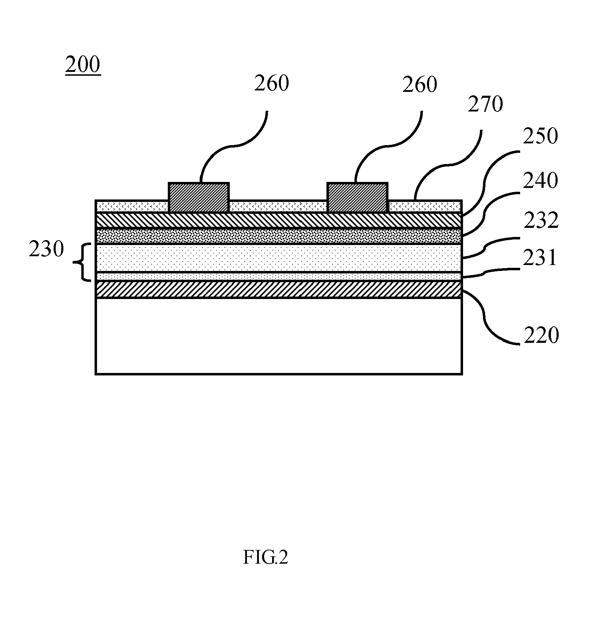

Referring to FIG.2, it is a schematic view of a CZTS-based photovoltaic device according to an embodiment of the present application.

As shown in FIG.2, the photovoltaic device 200 includes a substrate 210, a bottom electrode layer 220, an absorber layer 230, a buffer layer 240, a top electrode layer 250, metal contacts 260, and an anti-reflective layer 270. The bottom electrode layer 220 is formed on the substrate 210. The absorber layer 230 is formed on the bottom electrode layer 220. The buffer layer 240 is formed on the absorber layer 230. The top electrode layer 250 is formed on the buffer layer 240. The metal contacts 260 are formed on the top electrode layer 250. The anti-reflective layer 270 is also formed on the top electrode layer 260 while exposing the metal contacts 260.

The absorber layer 230 includes a first region 231 and a second region 232. The first region 231 is adjacent to the bottom electrode layer 220. The second region 232 is adjacent to the first region 231. The second region 232 can be considered as a main region of the absorber layer which includes a main composition of the absorber layer. The first region 231 includes a chemical composition with a higher Zn/Sn ratio than that of the second region 232. By combination of the first region and the second region, the absorber layer 230 thus includes a gradient Zn/Sn ratio.

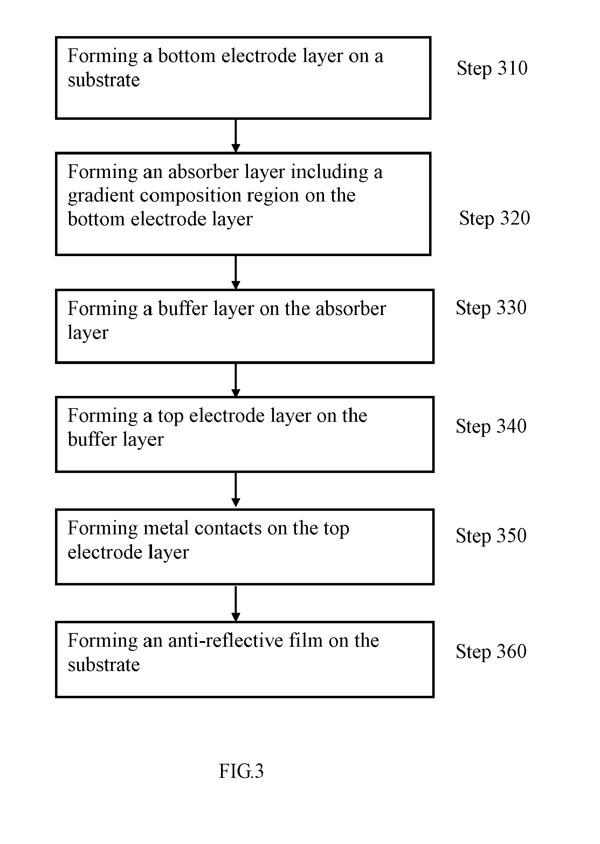

Referring to FIG.3, it is a flow chart of forming a CZTS-based photovoltaic device according to the embodiment shown in FIG.2.

As shown in FIG.3, the method includes a step 310 of forming the bottom electrode layer 220 on the substrate 210. The substrate can be rigid, such as, glass substrate, or flexible, such as metal foil or plastic substrate. The bottom electrode layer 210 includes a material selected from a group consisting of molybdenum (Mo), tungsten (W), aluminum (Al), and indium tin oxide (ITO). In this embodiment, an Mo layer 210 of about 500 nm to about 1000 nm is formed on the substrate 200 by sputtering.

Step 320 includes forming the absorber layer 230 including a gradient composition region on the bottom layer electrode layer 220. The gradient composition region refers to the first region 231 and the second region 232 shown in FIG.2. The absorber layer, for example, can be formed by a wet-coating method. However, other methods such as electron-beam evaporation, vapor deposition, sputtering, electro-plating, or sol-gel method, spray pyrolysis, spray deposition, radiofrequency magnetron sputtering, or electrochemical deposition also can be used.

The wet-coating method includes steps of coating a first CZTS precursor solution with a first Zn/Sn ratio to form a first liquid layer on the bottom electrode layer 220 and drying the first liquid layer to form a first precursor layer, coating a second CZTS precursor solution with a second Zn/Sn ratio which is lower than the first Zn/Sn ratio to form a second liquid layer on the first precursor layer and drying the second liquid layer to form a second precursor layer, and then annealing the first precursor layer and the second precursor layer to form the absorber layer 230. Since the absorber layer 230 is formed by the first precursor layer and the second precursor layer which respectively include a higher Zn/Sn ratio and a lower Zn/Sn ratio, the absorber layer 230 includes a gradient composition region having gradient Zn/Sn ratio. It shall be noted here that even though only the gradient composition region, i.e., constituted by the first region 231 and the second region 232, is included in the absorber layer 230 in this embodiment, additional regions with different composition, i.e., Zn/Sn ratio, also can be formed above the gradient composition region and be included in the absorber layer 230.

The coating method as mentioned above can be, but not limited to, drop casting, spin coating, dip coating, doctor blading, curtain coating, slide coating, spraying, slit casting, meniscus coating, screen printing, ink jet printing, pad printing, flexographic printing or gravure printing.

The drying process can be carried out at a temperature from about 25 °C to 600 °C, preferably, from 350 °C to 480 °C. The annealing temperature of the precursor film of CZTS can be from about 300 °C to 700 °C, preferably, from 480 °C to 650 °C. The absorber layer 230 formed on the Mo layer 220 includes a thickness from about 0.6 $\mu$m to about 6 $\mu$m.

Step 330 includes forming a buffer layer 240 on the absorber layer 230. The buffer layer 240 includes a semiconductor layer, such as an n-type semiconductor layer or a p-type semiconductor layer. For example, the buffer layer includes a material selected from a group consisting of cadmium sulfide (CdS), Zn(O,OH,S), indium selenide (In2Se3) zinc sulfide (ZnS), and zinc magnesium oxide ($Zn_xMg_{1-x}O$). In this embodiment, a CdS layer 240 is formed as an n-type semiconductor layer on the absorber layer 230. The CdS film 240 can be formed by chemical bath deposition method. In this embodiment, the thickness of the CdS film 240 can be, for example, about 20nm to about 150nm.

Step 340 includes forming a top electrode 250 layer on the buffer layer 240. The top electrode includes a transparent conductive layer. For example, the top electrode layer 250 includes a material selected from a group consisting of zinc oxide (ZnO), indium tin oxide (ITO), boron-doped zinc oxide (B-ZnO), aluminum-doped zinc oxide (Al-ZnO), gallium-doped zinc oxide (Ga-ZnO), and antimony tin oxide (ATO). In this embodiment, a zinc oxide (ZnO) film of a thickness of about 100nm and an indium tin oxide film (ITO) of a thickness of about 130nm are formed as the top electrode layer 250 on the buffer layer 240. The method for forming the ZnO film and the ITO film can be, for example, sputtering.

The method of fabricating the photovoltaic device can further include step 350 and step 360.

Step 350 includes forming metal contacts 260 on the top electrode layer 250. The metal contacts 260 can be silver, gold, or nickel (Ni)/ aluminum (Al) layers. The method of forming Ni/Al metal contacts 260 can be, for example, electron-beam evaporation.

Step 360 includes forming an anti-reflective film 270 on the substrate 210. For example, the anti-reflective film includes a material selected from a group consisting of magnesium fluoride ($MgF_2$), silicon oxide ($SiO_2$) silicon nitride ($Si_3N_4$) and Niobium oxide ($NbO_x$). In this embodiment, a $MgF_2$ film 270 is formed on the substrate as the anti-reflective film. The $MgF_2$ film can be formed by, for example, electron-beam evaporation. In this embodiment, the thickness of the magnesium fluoride ($MgF_2$) film can be, for example, 110nm.

Hereinafter, several examples of forming a photovoltaic device with an absorber layer including a gradient composition region will be described. It shall be noted that even though hydrazine-based precursor solutions, i.e., CZTS precursor solutions which use hydrazine as a solvent, were used in the following examples, non-hydrazine-based precursor solutions, i.e., CZTS precursor solutions which no hydrazine is used as a solvent, can also be used to form the absorber layer.

Example 1

Preparation of a first Zn/Sn ratio CZTS precursor solution: 0.573g of copper sulfide ($Cu_2S$) and 0.232g of sulfur were dissolved in 3.0ml of hydrazine to form a solution (A1). 1.736g of selenium (Se), 0.32g of zinc (Zn) and 0.79g of tin selenide (SnSe) were dissolved in 7ml of hydrazine to form solution (B1). Both of these two solutions were stirred for 3 days, and then the solutions (A1) and (B1) were mixed to form a first precursor solution (C1). The first precursor solution (C1) included a chemical composition of $Cu_{0.8}Zn_{0.55}Sn_{0.45}S_{1.2}Se_{2.9}$ and a Zn/Sn ratio = 1.22.

Preparation of a second Zn/Sn ratio CZTS precursor solution: 0.465g of copper sulfide (Cu2S) and 0.232g of sulfur were dissolved in 3ml of hydrazine to form a solution (A2). 1.58g of selenium (Se), 0.22g of zinc (Zn) and 0.79g of tin selenide (SnSe) were dissolved in 7ml of hydrazine to form solution (B2). Both of these two solutions were stirred for 3 days, and then the solutions (A2) and (B2) were mixed to form a second precursor solution (C2). The second precursor solution (C2) included a chemical composition of Cu0.8Zn0.45Sn0.55S1.1 Se2.7 and a Zn/Sn ratio = 0.83.

Fabrication of photovoltaic device

First, a metal layer, for example, an Mo layer, was sputtered on a soda-lime glass substrate.

Next, the first precursor solution (C1) having Zn/Sn ratio = 1.22 was coated to form a first liquid layer on the Mo layer. The first liquid layer was dried to form a first precursor layer of about $0.5\mu m$ on the Mo layer.

Then, the second precursor solution (C2) having Zn/Sn ratio = 0.83 was coated to form a second liquid layer on the first precursor layer. The second liquid layer was dried to form a second precursor layer of about $3\mu m$ on the first precursor layer. For example, the drying temperature is about 425 °C.

The first precursor layer and the second precursor layer were annealed at a temperature of about 540 °C for 10 minutes to form an absorber layer on the Mo layer. The absorber layer included a gradient composition region constituted by the first precursor layer and the second precursor layer which a Zn/Sn ratio of the first precursor layer is higher than that of the second precursor layer. In this example, the annealing process was performed under sulfur-containing atmosphere without oxygen. However, in other examples, other conditions such as sulfur-free atmosphere or trace oxygen (several ppm)-containing atmosphere also can be used in the annealing process.

Then, a CdS layer of about 60nm was deposited on the absorber layer as an n-type semiconductor layer. The CdS layer can be deposited by, for example, chemical bath deposition. A ZnO layer of about 100nm and an ITO layer of about 130nm were deposited on the CdS layer as a top electrode layer. The method of forming ZnO and ITO layer can be, for example, sputtering. Then, Ni/Al metal contacts and a MgF anti-reflective layer were sequentially deposited on the top electrode layer by, for example, electron beam evaporation.

Comparative Example 1

The photovoltaic device of Comparative Example 1 was obtained by the same method of Example 1 except that the step of coating the first precursor solution (C1) was omitted. Thus, the absorber layer was formed with the second precursor solution (C2) and only included a main region. There were no first regions formed between the bottom electrode layer and the main region of the absorber layer.

Evaluation of photovoltaic device

The open-circuit voltage (Voc), short-circuit current (Jsc), fill factor (F.F.) and conversion efficiency ($\eta$) of the

photovoltaic devices of Example 1 and Comparative Example 1 were determined and listed in Table 1.

According to Table 1, Example 1 was seen to exhibit an open circuit voltage higher than that of Comparative Example 1. Thus, it was found that according to the embodiment of the present application that the open circuit voltage of a CZTS-based photovoltaic device was increased by using an absorber layer including a gradient composition region which includes a higher Zn/Sn ratio at a side adjacent to the bottom electrode layer.

TABLE 1

|  | $V_{oc}$(mV) | $J_{sc}$ (mA/cm$^2$) | F.F. (%) | Eff. (%) |
|---|---|---|---|---|
| Example 1 | 420 | 27.7 | 62.6 | 7.3 |
| Comparative Example 1 | 370 | 26.2 | 60.2 | 5.8 |

Example 2

Preparation of a first Zn/Sn ratio CZTS precursor solution: 0.573g of copper sulfide (Cu$_2$S) and 0.232g of sulfur were dissolved in 3.0ml of hydrazine to form a solution (A3). 2.054g of selenium (Se), 0.349g of zinc (Zn) and 0.426g of tin (Sn) were dissolved in 7ml of hydrazine to form solution (B3). Both of these two solutions were stirred for 3 days, the solutions (A3) and (B3) were mixed to form a first precursor solution (C3). The first precursor solution (C3) included a chemical composition of Cu$_{0.8}$Zn$_{0.6}$Sn$_{0.40}$S$_{1.1}$Se$_{2.9}$ and a Zn/Sn ratio = 1.5.

Preparation of a second Zn/Sn ratio CZTS precursor solution: 0.573g of copper sulfide (Cu$_2$S) and 0.232g of sulfur were dissolved in 3.0ml of hydrazine to form a solution (A4). 2.054g of selenium (Se), 0.32g of zinc (Zn) and 0.48g of tin (Sn) were dissolved in 7ml of hydrazine to form solution (B4). Both of these two solutions were stirred for 3 days, and then the solutions (A4) and (B4) were mixed to form a second precursor solution (C4). The second precursor solution (C4) included a chemical composition of Cu$_{0.8}$Zn$_{0.55}$Sn$_{0.45}$S$_{1.2}$Se$_{2.9}$ and a Zn/Sn ratio = 1.22.

Preparation of a third Zn/Sn ratio CZTS precursor solution: 0.573g of copper sulfide (Cu$_2$S) and 0.232g of sulfur were dissolved in 3.0ml of hydrazine to form a solution (A5). 2.054g of selenium (Se), 0.262g of zinc (Zn) and 0.585g of tin (Sn) were dissolved in 7ml of hydrazine to form solution (B5). Both of these two solutions were stirred for 3 days, the solutions (A5) and (B5) were mixed to form a third precursor solution (C5). The third precursor solution (C5) included a chemical composition of Cu$_{0.8}$Zn$_{0.45}$Sn$_{0.55}$S$_{1.1}$Se$_{2.9}$ and a Zn/Sn ratio = 0.83.

Fabrication of photovoltaic device of Example 2

After forming an Mo layer as a bottom electrode layer on a substrate, a first precursor solution (C3) having a composition of Zn/Sn ratio = 1.5 was coated to form a first liquid layer on the Mo layer. Then, the first liquid layer was dried to form a first precursor layer of about 0.5μm.

Next, a second precursor solution (C4) having a composition of Zn/Sn =1.22 was coated on the first precursor layer to form a second liquid layer and then dried to form a second precursor layer of about 3μm.

The first precursor layer and the second precursor layer were annealed to form an absorber layer on the Mo layer.

Then, an n-type semiconductor layer, a top electrode layer and metal contacts were sequentially deposited on the absorber layer to form a photovoltaic device.

Comparative Example 2-1

The photovoltaic device of Comparative Example 2-1 was obtained by the same method of Example 2 except that the first precursor solution (C3) is omitted.

Comparative Example 2-2

The photovoltaic device of Comparative Example 2-2 was obtained by the same method of Example 2 except that the first precursor solution (C3) having a composition of Zn/Sn ratio = 1.5 is replaced with the third precursor solution (C5) having a composition of Zn/Sn ratio = 0.83.

Evaluation of photovoltaic device

The open-circuit voltage (Voc), short-circuit current (Jsc), fill factor (F.F.) and conversion efficiency (η) of the photovoltaic devices of Example 2, Comparative Example 2-1 and Comparative Example 2-2 were determined and listed in Table 2.

TABLE 2

|  | $V_{oc}$ (mV) | $J_{sc}$ (mA/cm$^2$) | F.F. (%) | Eff. (%) |
|---|---|---|---|---|
| Example 2 | 492 | 22.1 | 59 | 6.4 |
| Comparative Example 2-1 | 468 | 24.1 | 57 | 6.4 |
| Comparative Example 2-2 | 425 | 17.2 | 55 | 4.0 |

According to Table 2, Example 2 was seen to exhibit the open circuit voltage higher than that of Comparative Example 2-1. It was found again that the open circuit voltage of a CZTS-based photovoltaic device can be increased by forming a first region with a higher Zn/Sn ratio than that of a second region of the absorber layer between the bottom electrode layer and the second region.

Moreover, according to Table 2, it was found that Comparative Example 2-2 was seen to exhibit the open circuit voltage lower than that of Comparative Example 2-1. That is, the photovoltaic device formed with the absorber layer including a first region with a lower Zn/Sn ratio than that of the second region was found to have a decreased open circuit voltage.

Example 3

Preparation of a first Zn/Sn ratio CZTS precursor: 0.573g of copper sulfide (Cu$_2$S) and 0.232g of sulfur were dissolved in 3.0ml of hydrazine to form a solution (A6). 2.054g of selenium (Se), 0.388g of zinc (Zn) and 0.354g of tin (Sn) were dissolved in 7ml of hydrazine to form solution (B6). Both of these two solutions were stirred for 3 days, the solutions (A6) and (B6) were mixed to form a first precursor solution (C6). The first precursor solution (C6) included a chemical composition of Cu$_{0.8}$Zn$_{0.67}$Sn$_{0.33}$S$_{1.1}$Se$_{2.9}$ and a Zn/Sn ratio = 2.0.

Preparation of a second Zn/Sn ratio CZTS precursor: 0.573g of copper sulfide (Cu$_2$S) and 0.232g of sulfur were dissolved in 3.0ml of hydrazine to form a solution (A7). 2.054g of selenium (Se), 0.32g of zinc (Zn) and 0.48g of tin (Sn) were dissolved in 7ml of hydrazine to form solution (B7). Both of these two solutions were stirred for 3 days, and then the solutions (A7) and (B7) were mixed to form a second precursor solution (C7). The second precursor solution (C7) included a chemical composition of Cu$_{0.8}$Zn$_{0.55}$Sn$_{0.45}$S$_{1.2}$Se$_{2.9}$ and a Zn/Sn ratio = 1.22.

Fabrication of photovoltaic device of Example 3

After forming an Mo layer as a bottom electrode layer on a substrate, a first precursor solution (C6) having a composition of Zn/Sn ratio = 2.0 was coated to form a first liquid layer on the Mo layer. Then, the first liquid layer was dried to form a first precursor layer of about 0.5$\mu$m.

Next, a second precursor solution (C7) having a composition of Zn/Sn =1.22 was coated on the first precursor layer to form a second liquid layer and then dried to form a second precursor layer of about 3$\mu$m.

The first precursor layer and the second precursor layer were annealed to form an absorber layer on the Mo layer.

Then, an n-type semiconductor layer, a top electrode layer and metal contacts were sequentially deposited on the absorber layer to form a photovoltaic device.

Comparative Example 3

The photovoltaic device of Comparative Example 3 was obtained by the same method of Example 3 except that the first precursor solution (C6) is omitted.

Evaluation of photovoltaic device

The open-circuit voltage (Voc), short-circuit current (Jsc), fill factor (F.F.) and conversion efficiency ($\eta$) of the photovoltaic devices of Example 3 and Comparative Example 3 were determined and listed in Table 3.

Table 3

|  | $V_{oc}$ (mV) | $J_{sc}$ (mA/cm$^2$) | F.F. (%) | Eff. (%) |
|---|---|---|---|---|
| Example 3 | 433 | 23.6 | 46.6 | 4.8 |
| Comparative Example 3 | 386 | 23.8 | 36.6 | 3.4 |

According to Table 3, Example 3 was seen to exhibit the open circuit voltage higher than that of Comparative Example 3.

Thus, according to the embodiments shown above, it was verified that an open circuit voltage of a CZTS-based photovoltaic device can be increased by forming an absorber layer with a higher Zn/Sn ratio region adjacent to the bottom electrode layer.

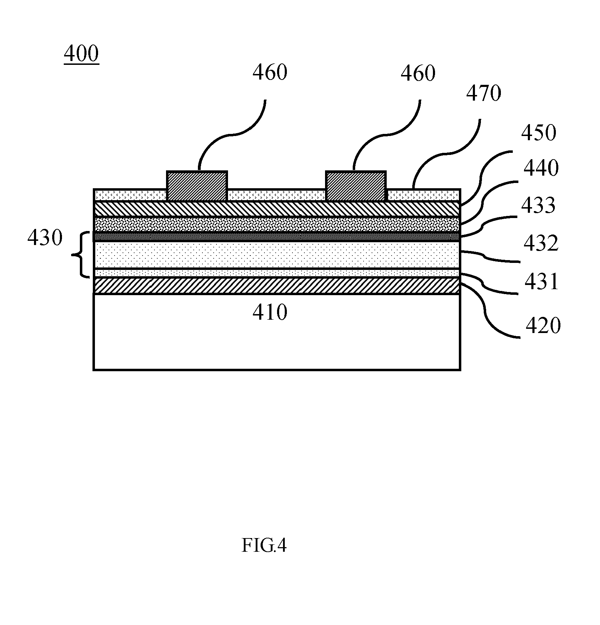

Referring to FIG.4, it is a schematic view of a CZTS-based photovoltaic device according to another embodiment of the present application. As shown in FIG.4, the photovoltaic device 400 includes a substrate 410, a bottom electrode layer 420, an absorber layer 430, a buffer layer 440, a top electrode layer 450, metal contacts 460, and an anti-reflective layer 470.

The bottom electrode layer 420 is formed on the substrate 410. The absorber layer 430 is formed on the bottom electrode layer 420. The buffer layer 440 is formed on the absorber layer 430. The top electrode layer 450 is formed on the buffer layer 440. The metal contacts 460 are formed on the top electrode layer 450. The anti-reflective layer 470 is also formed on the top electrode layer 460 while exposing the metal contacts 460.

The absorber layer 430 includes a bottom region 431, a main region 432 and an upper region 433. The bottom region 431 is adjacent to the bottom electrode layer 420, the upper region 433 is adjacent to the top electrode layer 440 and the main region which constitutes a major part of the absorber layer is positioned between the bottom region and the upper region. All of these three regions are formed with a formula of $Cu_a(Zn_{1-b}Sn_b)(Se_{1-c}S_c)_2$, wherein $0<a<1$, $0<b<1$, $0 \leqq c \leqq 1$, while the bottom region 431 is formed with a composition of a Zn/Sn ratio higher than that of the main region 432. The main region 432 is formed with a main composition of the absorber layer. The upper region 433 can be formed with compositions different from the bottom region 431 and the main region 432.

The manufacturing method of the photovoltaic device 400 is similar to the method shown in FIG.3. Therefore, the manufacturing process is omitted here for simplification.

Following is an example used to demonstrate the structure and features of the photovoltaic device shown in FIG.4.

Example 4

Preparation of precursor solutions

In Example 4, the first precursor solution (C3), the second precursor solution (C4) and the third precursor solution (C5) were prepared by the same method as shown in Example 2.

Fabrication of photovoltaic device of Example 4

After forming an Mo layer as a bottom electrode layer on a substrate, the first precursor solution (C3) having a Zn/Sn ratio = 1.5 was coated to form a first liquid layer on the bottom electrode layer. Then, the first liquid layer was dried to form a first precursor layer of about $0.5\mu m$. The first precursor layer constituted a bottom region of the absorber layer.

Next, the second precursor solution (C4) having a Zn/Sn ratio = 1.22 was coated to form a second liquid layer on the first precursor layer. The second liquid layer was dried to form a second precursor layer of about $2.5\mu m$. The second precursor layer constituted a main region of the absorber layer. The composition of the main region can be considered as a main composition of the absorber layer. Then, the third precursor solution (C5) having a Zn/Sn ratio = 0.83 was further coated on the second precursor layer to form a third liquid layer. The third liquid layer was dried to form a third precursor layer of about $0.5\mu m$. The third precursor layer constituted an upper region of the absorber layer.

The first precursor layer, the second precursor layer and the third precursor layer were annealed to form an absorber layer on the Mo layer. Thereafter, an n-type semiconductor layer, a top electrode layer and metal contacts were sequentially formed on the absorber layer.

Comparative Example 4

The photovoltaic device of Comparative Example 4 was obtained by the same method of Example 4 except that the first precursor solution (C3) is omitted. That is, the absorber layer of this example is formed with a main region having a Zn/Sn ratio = 1.22 and an upper region having a Zn/Sn ratio = 0.83.

Evaluation of photovoltaic device

The open-circuit voltage (Voc), short-circuit current (Jsc), fill factor (F.F.) and conversion efficiency ($\eta$) of the photovoltaic devices of Example 4 and Comparative Example 4 were determined and listed in Table 4.

TABLE 4

| | $V_{oc}$ (mV) | $J_{sc}$ (mA/cm$^2$) | F.F. (%) | Eff. (%) |
|---|---|---|---|---|
| Example 4 | 460 | 26.2 | 62 | 7.4 |
| Comparative Example 4 | 420 | 31.0 | 61 | 7.8 |

According to Table 4, Example 4 was seen to exhibit an open circuit voltage higher than that of Comparative Example 4. That is, it was verified again that a higher Zn/Sn ratio region between the bottom electrode layer and the main region of the absorber layer can increase an open circuit voltage of a CZTS-based photovoltaic device.

Besides, Example 4 is different from Example 2 in that a low Zn/Sn ratio region is formed above the main region of the absorber layer, i.e., the third precursor solution (C5) having Zn/Sn ratio =0.83 is coated and dried on the second precursor layer. Similarly, Comparative Example 4 is different from Comparative Example 2-1 with the same difference.

It was shown in Table 4 that even though an upper region with a different composition, such as a Zn/Sn ratio = 0.83, was formed in the absorber layer, an open circuit voltage of the photovoltaic device was also increased by forming a higher Zn/Sn ratio region nearby the bottom electrode layer.

## Claims

1. A photovoltaic device (200, 400) including a CZTS absorber layer (230, 430), **characterized by**:

   a substrate (210, 410);
   a bottom electrode layer (220, 420);
   an absorber layer (230, 430), formed on the bottom electrode layer (220, 420);
   a buffer layer (240, 440), formed on the absorber layer (230, 430); and
   a top electrode layer (250, 450), formed on the buffer layer (240, 440);
   wherein the absorber layer (230, 430) includes a first region (231, 431) adjacent to the bottom electrode layer (220, 420) and a second region (232, 432) adjacent to the first region (231, 431), both of the first region (231, 431) and the second region (232, 432) include a formula of $Cu_a(Zn_{1-b}Sn_b)(Se_{1-c}S_c)_2$, wherein $0<a<1$, $0<b<1$, $0 \leqq c \leqq 1$ and a Zn/Sn ratio of the first region (231, 431) is higher than that of the second region (232, 432).

2. The photovoltaic device (200, 400) according to claim 1, **characterized in that** a thickness of the second region (232, 432) of the absorber layer (230, 430) is larger than that of the first region (231, 431) of the absorber layer (230, 430).

3. The photovoltaic device (200, 400) according to claim 1, **characterized in that** the second region (232, 432) of the absorber layer (230, 430) is adjacent to the buffer layer (240, 440).

4. The photovoltaic device (200, 400) according to claim 1, **characterized in that** the bottom electrode layer (220, 420) includes a material selected from a group consisted of molybdenum (Mo), tungsten (W), aluminum (Al), and Indium Tin Oxide (ITO).

5. The photovoltaic device (200, 400) according to claim 1, **characterized in that** the buffer layer (240, 440) includes an n-type semiconductor layer.

6. The photovoltaic device (200, 400) according to claim 5, **characterized in that** the n-type semiconductor layer includes a material selected from a group consisted of cadmium sulfide (CdS), Zn(O,OH,S), indium selenide ($In_2Se_3$), zinc sulfide (ZnS), and zinc magnesium oxide ($Zn_xMg_{1-x}O$).

7. The photovoltaic device (200, 400) according to claim 1, **characterized in that** the top electrode layer (250, 450) includes a material selected from a group consisting of zinc oxide (ZnO), indium tin oxide (ITO), boron-doped zinc oxide (B-ZnO), aluminum-doped zinc oxide (Al-ZnO), gallium-doped zinc oxide (Ga-ZnO), and antimony tin oxide (ATO).

8. The photovoltaic device (200, 400) according to claim 1, **characterized in that** the Zn/Sn ratio of the first region (231, 431) is of about 1.22 to about 2.0.

9. The photovoltaic device (100, 200, 400) according to claim 1, **characterized in that** the Zn/Sn ratio of the second region (232, 432) is of about 0.83 to about 1.22.

10. A method for manufacturing a photovoltaic device (200, 400) including a CZTS absorber layer (230, 430), **characterized by**:

    forming a bottom electrode layer (220, 420) on a substrate (210, 410);
    forming an absorber layer (230, 430) including a gradient composition region on the bottom electrode layer (220, 420);
    forming a semiconductor layer (240, 440) on the absorber layer (230, 430); and
    forming a top electrode layer (250, 450) on the semiconductor layer (140, 240, 440); wherein the absorber layer (230, 430) includes a formula of $Cu_a(Zn_{1-b}Sn_b)(Se_{1-c}S_c)_2$, wherein $0<a<1$, $0<b<1$, $0\leqq c\leqq 1$, and the gradient composition region includes gradient Zn/Sn ratio and a higher Zn/Sn ratio at a side adjacent to the bottom electrode layer (220, 420).

11. The method according to claim 10, **characterized in that** the step of forming the absorber layer (230, 430) includes at least one selected from the group consisting of coating, electron-beam evaporation, vapor deposition, sputtering, electro-plating, or sol-gel method, spray pyrolysis, spray deposition, radiofrequency magnetron sputtering and electrochemical deposition.

12. The method according to claim 10, **characterized in that** the step of forming the gradient composition region of the absorber layer (230, 430) includes:

    forming a first precursor layer with a first Zn/Sn ratio on the bottom electrode layer (220, 420);
    forming a second precursor layer with a second Zn/Sn ratio which is lower than the first Zn/Sn ratio on the first precursor layer; and
    annealing the first precursor layer and the second precursor layer.

13. The method according to claim 12, further comprising:

    coating a first precursor solution to form a first liquid layer on the bottom electrode layer (220, 420);
    drying the first liquid layer to form the first precursor layer; and
    coating a second precursor solution to form a second liquid layer on the first precursor layer; and
    drying the second liquid layer to form the second precursor layer.

14. The method according to claim 13, further comprising forming the second precursor layer with a thickness larger than that of the first precursor layer.

15. The method according to claim 13, **characterized in that** at least one of the first precursor solution and the second precursor solution includes hydrazine-based precursor solutions or non-hydrazine-based precursor solutions.

100

160     160     170

150

140

130

110     120

FIG.1

FIG.2

| | |
|---|---|
| Forming a bottom electrode layer on a substrate | Step 310 |

↓

| | |
|---|---|
| Forming an absorber layer including a gradient composition region on the bottom electrode layer | Step 320 |

↓

| | |
|---|---|
| Forming a buffer layer on the absorber layer | Step 330 |

↓

| | |
|---|---|
| Forming a top electrode layer on the buffer layer | Step 340 |

↓

| | |
|---|---|
| Forming metal contacts on the top electrode layer | Step 350 |

↓

| | |
|---|---|
| Forming an anti-reflective film on the substrate | Step 360 |

FIG.3

FIG.4